(19) Europäisches Patentamt
European Patent Office
Office européen des brevets

(11) **EP 4 207 432 B1**

(12) **EUROPEAN PATENT SPECIFICATION**

(45) Date of publication and mention
of the grant of the patent:
**24.04.2024 Bulletin 2024/17**

(21) Application number: **22212249.1**

(22) Date of filing: **08.12.2022**

(51) International Patent Classification (IPC):
***H01M 10/48*** *(2006.01)* ***G01R 31/367*** *(2019.01)*
***H01M 10/633*** *(2014.01)*

(52) Cooperative Patent Classification (CPC):
**H01M 10/48; G01R 31/367; G01R 31/392;
H01M 10/425; H01M 10/486;** H01M 2010/4278;
H01M 2200/00; H01M 2220/20

(54) **METHOD AND SYSTEM FOR PREDICTING THERMAL RUNAWAY OF BATTERY BASED ON MACHINE LEARNING**

VERFAHREN UND SYSTEM ZUR VORHERSAGE DES THERMISCHEN DURCHGEHENS EINER BATTERIE AUF DER BASIS VON MASCHINENLERNEN

PROCÉDÉ ET SYSTÈME DE PRÉDICTION D'EMBALLEMENT THERMIQUE DE BATTERIE SUR LA BASE D'UN APPRENTISSAGE AUTOMATIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **30.12.2021 CN 202111657836**

(43) Date of publication of application:
**05.07.2023 Bulletin 2023/27**

(73) Proprietor: **Chongqing Changan New Energy
Vehicles Technology Co., Ltd
Chongqing 401133 (CN)**

(72) Inventors:
• **YANG, Linxiao**
  **Chongqing, 401133 (CN)**
• **DENG, Chenghao**
  **Chongqing, 401133 (CN)**
• **MOU, Liasha**
  **Chongqing, 401133 (CN)**
• **ZHU, Qian**
  **Chongqing, 401133 (CN)**
• **DING, Can**
  **Chongqing, 401133 (CN)**

(74) Representative: **2K Patentanwälte Blasberg
Kewitz & Reichel
Partnerschaft mbB
Schumannstrasse 27
60325 Frankfurt am Main (DE)**

(56) References cited:
**CN-A- 113 013 514      CN-A- 113 085 555**

• **WAN CHANGJIANG ET AL: "A Voltage Sensor
Fault Diagnosis Method Based on Long
Short-Term Memory Neural Networks for Battery
Energy Storage System", 2021 IEEE/IAS
INDUSTRIAL AND COMMERCIAL POWER
SYSTEM ASIA (I&CPS ASIA), IEEE, 18 July 2021
(2021-07-18), pages 163-167, XP034037517, DOI:
10.1109/ICPSASIA52756.2021.9621560 [retrieved
on 2021-11-18]**

**Description**

TECHNICAL FIELD

The disclosure belongs to the technical field of battery management systems, particularly to a technology for predicting thermal runaway of a battery based on machine learning.

BACKGROUND

The energy pressure of the current society is increasing. As a non-renewable resource, oil is obtained through the primary energy conversion of solar energy, and the conversion cycle is as long as millions of years. Due to the gradual strengthening of an awareness of the global environmental protection, fuel-powered vehicles and large-scale mechanical equipment are slowly being replaced by electric-driven products. A series of studies have proved that during the entire duration life cycle of a vehicle in service, the pollution caused by battery drive is far lower than that caused by oil drive. Lithium-ion battery vehicles have appeared in large numbers around us, which greatly reduces people's travel costs. However, due to the strong electrochemical activity of lithium batteries, during the charging and discharging process, lithium ions at the cell (single battery) level are quickly intercalated and extracted in the positive and negative electrode materials and diaphragm and cause irreversible damage to the structure, which not only affects the overall endurance capability of the vehicle, but also involves safety. Therefore, the entire industry and society are extremely concerned about the safety of thermal runaway of new energy vehicles. CN113013514 is relevant in this context.

The conventional experimental data of thermal runaway shows that when the battery is about to be in a state of thermal runaway, the temperature, voltage and pressure values will change drastically within a time period, and show a certain regularity. The current thermal runaway strategy is based on the characteristics of the cell itself and narrows the range of relevant parameters according to the thermal test of the battery pack. The thermal safety engineer determines the alarm threshold through data analysis, and reports a thermal runaway failure through a series of conditional combination arbitrations. This method has the following disadvantages:

First, the artificially determined threshold is extremely dependent on empirical values and contains subjectivity. Massive battery data may not be effectively used, and there is no way to evaluate the rationality of the threshold.

Second, the strategy needs to consider the special situation of sensor or other controller failures, and the strategy model needs to be continuously modified, which wastes the time and effort of R&D personnel, and the efficiency of human iteration is not high and error-prone.

Third, it is difficult to rely on the advantages of the cloud and technological progress to detect vehicle safety and update thermal runaway strategies at the level of big data.

SUMMARY

The disclosure provides a method and system for predicting thermal runaway of a battery based on a machine learning, which solves technical problems that a current thermal runaway strategy is based on characteristics of a cell itself and narrows a range of relevant parameters according to a thermal test of a battery pack, thermal safety engineer determines an alarm threshold through data analysis, and reports a thermal runaway failure through a series of conditional combination arbitrations. This strategy has the following disadvantages:

First, the artificially determined threshold is extremely dependent on empirical values and contains subjectivity. Massive battery data may not be effectively used, and there is no way to evaluate the rationality of the threshold.

Second, the strategy needs to consider the special situation of sensor or other controller failures, and the strategy model needs to be continuously modified, which wastes the time and effort of R&D personnel, and the efficiency of human iteration is not high and error-prone.

Third, it is difficult to rely on the advantages of the cloud and technological progress to detect vehicle safety and update thermal runaway strategies at the level of big data.

The disclosure provides the method for predicting thermal runaway of the battery based on the machine learning, the method includes:

S01: obtaining characteristic parameters related to thermal runaway data, wherein, the thermal runaway data are stored in a pre-established battery real database;
S02: dividing a training set and a testing set, wherein, both the training set and the testing set come from the real battery database;
S03: constructing a linear regression predictor for evolutionary operation;
S04: training the linear regression predictor based on the training set;
S05: predicting real parameters of the thermal runaway based on the testing set, which means inputting real data of the battery in the battery real database in S01 to the linear regression predictor, and comparing a predicted result of the linear regression predictor with the real data of the battery in the battery real database in S01.

In some embodiments, in the S03: the training set is divided into a plurality of small samples, after each iteration of a thermal runaway model, the small samples are traversed to calculate an average value of a gradient increment and parameters of the thermal runaway model are updated based on the average value of the gradient increment.

In some embodiments, in the S01: the characteristic parameters are module temperature, pressure and single voltage, wherein, a data source of the characteristic parameters are real-time data of a whole package of experimental burning, performance data of a battery core of a battery factory, normal working data of a whole vehicle test or field data recorded by vehicles with thermal runaway events which have been put into the market.

In some embodiments, the characteristic parameters further include a sampling failure and a communication failure.

In some embodiments, in the S04: combining a learning rate alpha with algorithm MBGD is used for an iterative training, and an average training cost of each iteration is recorded during a training process.

The disclosure further provides a system for predicting thermal runaway of a battery based on a machine learning, the system includes:

an obtaining module, configured to obtain characteristic parameters related to thermal runaway data, wherein, thermal runaway data are stored in a pre-established battery real database;

a dividing module, configured to divide a training set and a testing set, wherein, both the training set and the testing set come from the real battery database;

a constructing module, configured to construct a linear regression predictor for evolutionary operation;

a training module, configured to train the linear regression predictor based on the training set;

a comparing module, configured to predict real parameters of the thermal runaway based on the testing set, which means to input real data of the battery in the battery real database in the obtaining module to the linear regression predictor, and compare a predicted result of the linear regression predictor with the real data of the battery in the battery real database in the obtaining module.

In some embodiments, in the constructing module, the training set is divided into a plurality of small samples, after each iteration of a thermal runaway model, the small samples are traversed to calculate an average value of a gradient increment and parameters of the thermal runaway model are updated based on the average value of the gradient increment.

In some embodiments, in the obtaining module, the characteristic parameters are module temperature, pressure and single voltage, wherein, a data source of the characteristic parameters are real-time data of a whole package of experimental burning, performance data of a battery core of a battery factory, normal working data of a whole vehicle test or field data recorded by vehicles with thermal runaway events which have been put into the market.

In some embodiments, the characteristic parameters further comprise a sampling failure and a communication failure.

In some embodiments, in the training module, combining a learning rate alpha with algorithm MBGD is used for an iterative training, and an average training cost of each iteration is recorded during a training process.

Through the above technical method, beneficial technical effects of the disclosure are stated as follows: in the disclosure, data related to the thermal runaway is recorded (data samples are sufficiently large and detailed), the linear regression model constructed by machine learning is used to continuously improve (learn) the thermal runaway characteristics, and the data is quickly iterated to predict a thermal runaway state of the vehicle, and thermal runaway is reported when an eigenvalue (threshold) of the thermal runaway is met. Advantages of the disclosure are:

First, there is no need to provide a strategy manually.

Second, massive data is used to quickly iterate the model, which improves the eigenvalue of the thermal runaway state, effectively improves a determining accuracy of the thermal runaway and predicts a thermal event.

Third, an in-depth research on eigenvalue can enable basic scientists to understand battery thermal phenomena more deeply, and then realize a real battery revolution.

BRIEF DESCRIPTION OF THE DRAWINGS

The single FIG. is a schematic flow chart of a disclosure.

DETAILED DESCRIPTION

The disclosure will be further described below in conjunction with figures.

Please refer to the single FIG.. The disclosure provides a method for predicting thermal runaway of a battery based on a machine learning. In the method, a linear combination (eigenvalue) related to thermal runaway is found through a data input and repeated iteration of a model, so as to accurately predict thermal runaway events as early as possible.

The disclosure provides the method for predicting thermal runaway of the battery based on the machine learning, the method includes:

S01: obtaining characteristic parameters related to thermal runaway data, wherein, the thermal runaway data are stored in a pre-established battery real database;

S02: dividing a training set and a testing set, wherein, both the training set and the testing set come from the real battery database, the training set is a data set for a prediction model of the thermal runaway to do machine learning; the test set is a data set for verifying a learning degree of the prediction model of the thermal runaway after iteration;

S03: constructing a linear regression predictor for evolutionary operation;

Specifically, constructing a linear regression model:

defining a mathematical symbol: $D = \{(x^{(1)}, y^{(1)}), (x^{(2)}, y^{(2)}), ..., (x^{(m)}, y^{(m)})\}$, wherein m represents a size of the data set, $x(i) = (x_1^{(i)}, x_2^{(i)},..., x_n^{(i)})$, wherein n represents the number of attributes, $y^{(i)}$ is a real result corresponding to the input

sample $x^{(i)}$. A formulate is: $f_\theta(x) = \sum_{i=0}^{n} \theta_i x_i = \theta^T x$ , in order to achieve a goal (which means for each set of input data $x^{(i)}$, enabling the predicted value $f_\theta(x^{(i)})$ to be as close as possible to a real value $y^{(i)}$, or even equal), a cost function is defined: $L(\theta) = \frac{1}{2m} \sum_{i=1}^{n} [y^{(i)} - f_\theta(x^{(i)})]^2$ , $\theta$ is randomly generated as an initial value, and $\theta$ is continuously adjusted through machine learning to enable $L(\theta)$ to converge and then a minimum value is obtained.

A pseudo-code is:

$$m = \text{Data Size}$$

$$n = \text{Mini Batch Size}$$

Repeat until convergence {

for i = 1 to $\frac{m}{n}$:

$$w_j := w_j - \frac{\alpha}{n} \sum_{1}^{n} \Delta w_j \quad \text{(for every j)}$$

$$\Delta w_j^{(i)} = \frac{\partial}{\partial \theta_j} L(\theta) = \frac{1}{m} \sum_{i=1}^{m} [f_\theta(x^{(i)}) - y^{(i)}] x_j^{(i)}$$

}

Wherein w is a parameter to be optimized, and $\Delta w$ is a gradient increment of the parameter w.

A Python implementation(partial code) is:

```
#defining a linear regression class
Class Linear Regression(object):

    def _init_(self, input_data, realresult, theta=None): #initializing
    def Cost(self): #calculating the cost function
    def Shuffle_Sequence(self): #randomly shuffling an original dataset
    def MBGD(self, alpha, batch_size): #defining a mini-batch gradient descent algorithm function
    def train_MBGD(self, iter, mini_batch, alpha): # iterating training function
    def test(self, test_data): #testing the function
    def predict(self, data): #predicting the function
```

The following is a breakdown of several core functions:

```
#definig a mini-batch gradient descent algorithm function
def MBGD(self, alpha, batch_size):
    """
    : param alpha: learning rate
    : param batch_size: size of mini-batch sample
    """
    #defining a set of gradient increment
    gradient_increment = []
    #traversing a mini-batch training set, and updating the parameters of
the model by using an average value of the gradient increment
    for (data, result) in zip(Mini Train_Data,Mini Train_Result):
     # calculating a gradient increment of each set of the input data
and putting it into a increment set
     g = (result - data.dot(self.Theta))*data
     gradient_increment.append(g)
    #calculating the average value
    avg_g = np.average(gradient_increment, θ)
    #updating the parameters of the model
    self. Theta = self. Theta + alpha * avg_g
# MBGD training function
    """
    :param iter: the number of the iterations
    """
    # defining an average training cost set and recording an iteration cost
    Cost = [ ]
    S04: training the linear regression predictor based on the training set;
    Specifically, #starting an iterative training
    for i in range(iter):
     #combining a learning rate alpha with algorithm MBGD for the
iterative training
     Self. MBGD (alpha, batch_size)
     #recording an average training cost of each iteration
     Cost.append(self.Cost())
    Cost = np.array(Cost)
    return Cost
```

S05: predicting real parameters of the thermal runaway based on the testing set, which means inputting real data of the battery in the battery real database in S01 to the linear regression predictor, and comparing a predicted result of the linear regression predictor with the real data of the battery in the battery real database in S01.

Specifically, a next thermal runaway event is predicted based on a linear correlation value θ in a prediction function, and regression parameters are input into an optimization model again, and iteratively, under a condition of a large batch of data, it is constantly approaching ($\approx$) the real value.

The method of the disclosure may be used for massive data (cloud) monitoring, and may also be used under an offline condition (which requires a regular connection with a server to update the model). It observes and warns of a major thermal runaway risk in advance, and ensures a safety of life and property.

Specifically,
in the S03, the training set is divided into a plurality of small samples, after each iteration of a thermal runaway model, the small samples are traversed to calculate the average value of the gradient increment and parameters of the thermal runaway model are updated based on the average value of the gradient increment.

Specifically,
in the S01, the characteristic parameters are module temperature, pressure and single voltage, wherein, a data source of the characteristic parameters are real-time data of a whole package of experimental burning, performance data of a battery core of a battery factory, normal working data of a whole vehicle test or field data recorded by vehicles with thermal runaway events which have been put into the market.

Specifically,
The characteristic parameters further includes a sampling failure and a communication failure.

Specifically,
in the S04, combining the learning rate alpha with algorithm MBGD is used for the iterative training, and the average training cost of each iteration is recorded during a training process.

The disclosure further provides a system for predicting thermal runaway of a battery based on a machine learning, including:

**an** obtaining module, configured to obtain characteristic parameters related to thermal runaway data, wherein, thermal runaway data are stored in a pre-established battery real database;

**a** dividing module, configured to divide a training set and a testing set, wherein, both the training set and the testing set come from the real battery database, the training set is a data set for a prediction model of the thermal runaway to do machine learning; the test set is a data set for verifying a learning degree of the prediction model of the thermal runaway after iteration;

a constructing module, configured to construct a linear regression predictor for evolutionary operation;

a training module, configured to train the linear regression predictor based on the training set;

a comparing module, configured to predict real parameters of the thermal runaway based on the testing set, which means to input real data of the battery in the battery real database in the obtaining module to the linear regression predictor, and compare a predicted result of the linear regression predictor with the real data of the battery in the battery real database in the obtaining module.

Specifically,

in the constructing module, the training set is divided into a plurality of small samples, after each iteration of a thermal runaway model, the small samples are traversed to calculate an average value of a gradient increment and parameters of the thermal runaway model are updated based on the average value of the gradient increment.

Specifically,

in the obtaining module, the characteristic parameters are module temperature, pressure and single voltage, wherein, a data source of the characteristic parameters are real-time data of a whole package of experimental burning, performance data of a battery core of a battery factory, normal working data of a whole vehicle test or field data recorded by vehicles with thermal runaway events which have been put into the market.

Specifically,

the characteristic parameters further comprise a sampling failure and a communication failure.

Specifically,

in the training module, combining a learning rate alpha with algorithm MBGD is used for an iterative training, and an average training cost of each iteration is recorded during a training process.

It may be seen from the above embodiments that the disclosure utilizes the linear regression to design a mini-batch gradient descent algorithm (MBGD). Its characteristic is that the training set of random scrambling data is evenly divided into several small samples, and after each iteration of the model, the small samples are traversed to calculate the average value of gradient increment to adjust hyper-parameters. Firstly, the thermal runaway model is established, the relevant parameters such as temperature, pressure and voltage (single temperature rise, module overtemperature, single pressure difference, single undervoltage, pressure of the whole package) are input for "first learning", and the data comes from the real-time data of the whole package of experimental burning(If data sample is insufficient, please refer to simulation data or performance data of the battery core provided by the battery factory). In the same way, in a case of thermal runaway event in the vehicles put into the market, field data is recorded and feedbacked to improve the database and iteratively upgrade the model. It should be noted that sampling failure and communication failure are used as parameters related to thermal runaway, but they are not inevitable.

The object of the algorithm of the disclosure is: the linear combination (eigenvalue) related to thermal runaway is found through the data input and repeated iteration of the model, so as to accurately predict thermal runaway events as early as possible.

**Claims**

1. A method for predicting thermal runaway of a battery based on a machine learning, comprising:

    S01: obtaining characteristic parameters related to thermal runaway data, wherein, the thermal runaway data are stored in a pre-established battery real database;

    S02: dividing a training set and a testing set, wherein, both the training set and the testing set come from the real battery database;

    S03: constructing a linear regression predictor for evolutionary operation;

    S04: training the linear regression predictor based on the training set;

    S05: predicting real parameters of the thermal runaway based on the testing set, which means inputting real data of the battery in the battery real database in S01 to the linear regression predictor, and comparing a predicted result of the linear regression predictor with the real data of the battery in the battery real database in S01.

**2.** The method for predicting thermal runaway of the battery based on the machine learning according to claim 1, wherein in the S03, the training set is divided into a plurality of small samples, after each iteration of a thermal runaway model, the small samples are traversed to calculate an average value of a gradient increment and parameters of the thermal runaway model are updated based on the average value of the gradient increment.

**3.** The method for predicting thermal runaway of the battery based on the machine learning according to claim 1 or 2, wherein

in the S01, the characteristic parameters are module temperature, pressure and single voltage, wherein, a data source of the characteristic parameters are real-time data of a whole package of experimental burning, performance data of a battery core of a battery factory, normal working data of a whole vehicle test or field data recorded by vehicles with thermal runaway events which have been put into the market.

**4.** The method for predicting thermal runaway of the battery based on the machine learning according to claim 3, wherein the characteristic parameters further comprise a sampling failure and a communication failure.

**5.** The method for predicting thermal runaway of the battery based on the machine learning according to one of the preceding claims, wherein

in the S04, combining a learning rate alpha with algorithm MBGD is used for an iterative training, and an average training cost of each iteration is recorded during a training process.

**6.** A system for predicting thermal runaway of a battery based on a machine learning, comprising:

an obtaining module, configured to obtain characteristic parameters related to thermal runaway data, wherein, thermal runaway data are stored in a pre-established battery real database;
a dividing module, configured to divide a training set and a testing set, wherein, both the training set and the testing set come from the real battery database;
a constructing module, configured to construct a linear regression predictor for evolutionary operation;
a training module, configured to train the linear regression predictor based on the training set;
a comparing module, configured to predict real parameters of the thermal runaway based on the testing set, which means to input real data of the battery in the battery real database in the obtaining module to the linear regression predictor, and compare a predicted result of the linear regression predictor with the real data of the battery in the battery real database in the obtaining module.

**7.** The system for predicting thermal runaway of a battery based on a machine learning according to claim 6, wherein in the constructing module, the training set is divided into a plurality of small samples, after each iteration of a thermal runaway model, the small samples are traversed to calculate an average value of a gradient increment and parameters of the thermal runaway model are updated based on the average value of the gradient increment.

**8.** The system for predicting thermal runaway of a battery based on a machine learning according to claim 6 or 2, wherein in the obtaining module, the characteristic parameters are module temperature, pressure and single voltage, wherein, a data source of the characteristic parameters are real-time data of a whole package of experimental burning, performance data of a battery core of a battery factory, normal working data of a whole vehicle test or field data recorded by vehicles with thermal runaway events which have been put into the market.

**9.** The system for predicting thermal runaway of a battery based on a machine learning according to one of the claim 6-8, wherein
the characteristic parameters further comprise a sampling failure and a communication failure.

**10.** The system for predicting thermal runaway of a battery based on a machine learning according to one of the claims 6-9, wherein
in the training module, combining a learning rate alpha with algorithm MBGD is used for an iterative training, and an average training cost of each iteration is recorded during a training process.

**Patentansprüche**

**1.** Verfahren zur Vorhersage des thermischen Durchgehens einer Batterie auf der Grundlage von maschinellem Lernen, umfassend:

S01: Erhalten von charakteristischen Parametern, die sich auf die Daten des thermischen Durchgehens beziehen, wobei die Daten des thermischen Durchgehens in einer vorab erstellten realen Batteriedatenbank gespeichert werden;

S02: Aufteilen eines Trainingssatzes und eines Testsatzes, wobei sowohl der Trainingssatz als auch der Testsatz aus der realen Batteriedatenbank stammen;

S03: Konstruieren eines linearen Regressionsprädiktors für evolutionäre Operationen;

S04: Trainieren des linearen Regressionsprädiktors basierend auf dem Trainingssatz; und

S05: Vorhersagen von realen Parametern des thermischen Durchgehens auf der Grundlage des Testsatzes, was bedeutet, dass reale Batteriedaten in der realen Batteriedatenbank in S01 in den linearen Regressionsprädiktor eingegeben werden, und dass ein vorhergesagtes Ergebnis des linearen Regressionsprädiktors mit den realen Batteriedaten in der realen Batteriedatenbank in S01 verglichen wird.

2. Verfahren zur Vorhersage des thermischen Durchgehens einer Batterie auf der Grundlage von maschinellen Lernen nach Anspruch 1, wobei in der S03 der Trainingssatz in eine Vielzahl kleiner Stichproben unterteilt wird, wobei nach jeder Iteration eines thermischen Durchgehensmodells die kleinen Stichproben durchlaufen werden, um einen Durchschnittswert eines Gradienteninkrements zu berechnen, und wobei die Parameter des thermischen Durchgehensmodells auf der Grundlage des Durchschnittswerts des Gradienteninkrements aktualisiert werden.

3. Verfahren zur Vorhersage des thermischen Durchgehens einer Batterie auf der Grundlage von maschinellen Lernen nach Anspruch 1, wobei in der S01 die charakteristischen Parameter die Modultemperatur, der Druck und die Einzelspannung sind, wobei eine Datenquelle für die charakteristischen Parameter Echtzeitdaten eines ganzen Pakets von Versuchsverbrennungen, Leistungsdaten eines Batteriekerns einer Batteriefabrik, normale Arbeitsdaten eines Gesamtfahrzeugtests oder Felddaten sind, die von auf den Markt gebrachten Fahrzeugen mit thermischem Durchgehen aufgezeichnet wurden.

4. Verfahren zur Vorhersage des thermischen Durchgehens einer Batterie auf der Grundlage von maschinellen Lernen nach Anspruch 3, wobei die charakteristischen Parameter außerdem einen Abtastfehler und einen Kommunikationsfehler umfassen.

5. Verfahren zur Vorhersage des thermischen Durchgehens einer Batterie auf der Grundlage von maschinellen Lernen nach Anspruch 1, wobei in der S04 für ein iteratives Training die Kombination einer Lernrate alpha mit dem Algorithmus MBGD verwendet wird, wobei die durchschnittlichen Trainingskosten jeder Iteration während eines Trainingsprozesses aufgezeichnet werden.

6. System zur Vorhersage des thermischen Durchgehens einer Batterie auf der Grundlage von maschinellem Lernen, umfassend:

ein Erfassungsmodul, das so konfiguriert ist, dass es charakteristische Parameter erhält, die sich auf die Daten des thermischen Durchgehens beziehen, wobei die Daten des thermischen Durchgehens in einer vorab erstellten realen Batteriedatenbank gespeichert werden;

ein Aufteilungsmodul, das so konfiguriert ist, dass es einen Trainingssatz und einen Testsatz aufteilt, wobei sowohl der Trainingssatz als auch der Testsatz aus der realen Batteriedatenbank stammen;

ein Konstruktionsmodul, das so konfiguriert ist, dass es einen linearen Regressionsprädiktor für eine evolutionäre Operation konstruiert;

ein Trainingsmodul, das so konfiguriert ist, dass es den linearen Regressionsprädiktor basierend auf dem Trainingssatz trainiert;

ein Vergleichsmodul, das so konfiguriert ist, dass es reale Parameter des thermischen Durchgehens auf der Grundlage des Testsatzes vorhersagt, was bedeutet, dass es reale Batteriedaten in der realen Batteriedatenbank in S01 in den linearen Regressionsprädiktor eingibt und ein vorhergesagtes Ergebnis des linearen Regressionsprädiktors mit den realen Batteriedaten in der realen Batteriedatenbank in dem Erfassungsmodul vergleicht.

7. System zur Vorhersage des thermischen Durchgehens einer Batterie auf der Grundlage von maschinellen Lernen nach Anspruch 6, wobei in dem Konstruktionsmodul der Trainingssatz in eine Vielzahl von kleinen Stichproben unterteilt wird, wobei nach jeder Iteration eines thermischen Durchgehensmodells die kleinen Stichproben durchlaufen werden, um einen Durchschnittswert eines Gradienteninkrements zu berechnen, und wobei die Parameter des thermischen Durchgehensmodells auf der Grundlage des Durchschnittswerts des Gradienteninkrements aktualisiert werden.

**8.** System zur Vorhersage des thermischen Durchgehens einer Batterie auf der Grundlage von maschinellen Lernen nach Anspruch 6, wobei in dem Erfassungsmodul die charakteristischen Parameter die Modultemperatur, der Druck und die Einzelspannung sind, wobei eine Datenquelle für die charakteristischen Parameter Echtzeitdaten eines ganzen Pakets von Versuchsverbrennungen, Leistungsdaten eines Batteriekerns einer Batteriefabrik, normale Arbeitsdaten eines Gesamtfahrzeugtests oder Felddaten sind, die von auf den Markt gebrachten Fahrzeugen mit thermischem Durchgehen aufgezeichnet wurden.

**9.** System zur Vorhersage des thermischen Durchgehens einer Batterie auf der Grundlage von maschinellen Lernen nach Anspruch 6, wobei die charakteristischen Parameter außerdem einen Abtastfehler und einen Kommunikationsfehler umfassen.

**10.** System zur Vorhersage des thermischen Durchgehens einer Batterie auf der Grundlage von maschinellen Lernen nach Anspruch 6, wobei im Trainingsmodul für ein iteratives Training die Kombination einer Lernrate alpha mit dem Algorithmus MBGD verwendet wird, wobei die durchschnittlichen Trainingskosten jeder Iteration während eines Trainingsprozesses aufgezeichnet werden.

**Revendications**

**1.** Une méthode pour prédire l'emballement thermique d'une batterie basée sur l'apprentissage automatique, **caractérisé en ce qu'**elle comporte :

S01: obtenir des paramètres caractéristiques liés aux données d'emballement thermique, dans lesquelles les données d'emballement thermique sont stockées dans une base de données réelle de la batterie préétablie ;
S02 : diviser un ensemble d'exercices et un ensemble de tests, dans lesquels les deux ensembles provenant de la base de données réelle de la batterie ;
S03: construire un prédicteur de régression linéaire pour une opération évolutive ;
S04: exercer le prédicteur de régression linéaire sur la base de l'ensemble d'exercices ;
S05: prédire les paramètres réels de l'emballement thermique sur la base de l'ensemble de tests, ce qui signifie saisir les données réelles de la batterie dans la base de données réelle de la batterie en S01 dans le prédicteur de régression linéaire, et comparer un résultat prédit du prédicteur de régression linéaire avec les données réelles de la batterie dans la base de données réelle de la batterie en S01.

**2.** Méthode pour prédire l'emballement thermique de la batterie basée sur l'apprentissage automatique selon la Revendication 1, **caractérisé en ce que**,
dans le S03, l'ensemble d'exercices est divisé en plusieurs petits échantillons, après chaque itération d'un modèle d'emballement thermique, les petits échantillons sont parcourus pour calculer une valeur moyenne d'un incrément de gradient et les paramètres du modèle d'emballement thermique sont mis à jour sur la base de la valeur moyenne de l'incrément de gradient.

**3.** Méthode pour prédire l'emballement thermique de la batterie basée sur l'apprentissage automatique selon la Revendication 1, **caractérisé en ce que**,
dans le S01, les paramètres caractéristiques sont la température, la pression et la tension unique du module, dans laquelle, une source de données des paramètres caractéristiques sont des données en temps réel d'un ensemble complet de combustion expérimentale, des données de performances d'un noyau de batterie d'une usine de batteries, des données de fonctionnement normal d'un test de l'ensemble du véhicule ou des données de terrain enregistrées par des véhicules qui ont été mis sur le marché avec un événement d'emballement thermique apparu.

**4.** Méthode pour prédire l'emballement thermique de la batterie basée sur l'apprentissage automatique selon la Revendication 3, **caractérisé en ce que**,
les paramètres caractéristiques comprennent en outre un défaut d'échantillonnage et un défaut de communication.

**5.** Méthode pour prédire l'emballement thermique de la batterie basée sur l'apprentissage automatique selon la Revendication 1, **caractérisé en ce que**,
dans le S04, la combinaison d'un taux d'apprentissage alpha avec l'algorithme MBGD est utilisée pour une exercice itérative, et un coût d'exercice moyen de chaque itération est enregistré au cours d'un processus d'exercice.

**6.** Un système pour prédire l'emballement thermique d'une batterie basée sur l'apprentissage automatique, **caractérisé**

**en ce qu'**il comporte :

un module d'obtention, configuré pour obtenir des paramètres caractéristiques liés aux données d'emballement thermique, dans lesquelles les données d'emballement thermique sont stockées dans une base de données réelle de la batterie préétablie ;
un module de division, configuré pour diviser un ensemble d'exercices et un ensemble de tests, dans lesquels les deux ensembles provenant de la base de données réelle de la batterie ;
un module de construction, configuré pour construire un prédicteur de régression linéaire pour une opération évolutive ;
un module d'exercice, configuré pour exercer le prédicteur de régression linéaire sur la base de l'ensemble d'exercices ;
un module de comparaison, configuré pour prédire les paramètres réels de l'emballement thermique sur la base de l'ensemble de tests, ce qui signifie saisir les données réelles de la batterie dans la base de données réelle de la batterie dans le module d'obtention avec le prédicteur de régression linéaire, et comparer un résultat prédit du prédicteur de régression linéaire avec les données réelles de la batterie dans la base de données réelle de la batterie dans le module d'obtention.

7. Système pour prédire l'emballement thermique d'une batterie basée sur l'apprentissage automatique selon la Revendication 6, **caractérisé en ce que**,
dans le module de construction, l'ensemble d'exercices est divisé en plusieurs petits échantillons, après chaque itération d'un modèle d'emballement thermique, les petits échantillons sont parcourus pour calculer une valeur moyenne d'un incrément de gradient et les paramètres du modèle d'emballement thermique sont mis à jour sur la base de la valeur moyenne de l'incrément de gradient.

8. Système pour prédire l'emballement thermique d'une batterie basée sur l'apprentissage automatique selon la Revendication 6, **caractérisé en ce que**,
dans le module d'obtention, les paramètres caractéristiques sont la température, la pression et la tension unique du module, dans laquelle, une source de données des paramètres caractéristiques sont des données en temps réel d'un ensemble complet de combustion expérimentale, des données de performances d'un noyau de batterie d'une usine de batteries, des données de fonctionnement normal d'un test de l'ensemble du véhicule ou des données de terrain enregistrées par des véhicules qui ont été mis sur le marché avec un événement d'emballement thermique apparu.

9. Système pour prédire l'emballement thermique d'une batterie basée sur l'apprentissage automatique selon la Revendication 6, **caractérisé en ce que**,
les paramètres caractéristiques comprennent en outre un défaut d'échantillonnage et un défaut de communication.

10. Système pour prédire l'emballement thermique de la batterie basée sur l'apprentissage automatique selon la Revendication 6, **caractérisé en ce que**,
dans le module d'exercice, la combinaison d'un taux d'apprentissage alpha avec l'algorithme MBGD est utilisée pour une exercice itérative, et un coût d'exercice moyen de chaque itération est enregistré au cours d'un processus d'exercice.

establishing the database: Thermal Safety

S01:    input the performances: single voltage,
           module temperature, pressure

S02:  dividing the training set and the testing set

S03:  constructing the linear regression predictor
            for evolutionary operation

S04: training the linear regression predictor based
               on the training set

S04:      predicting based on the testing set

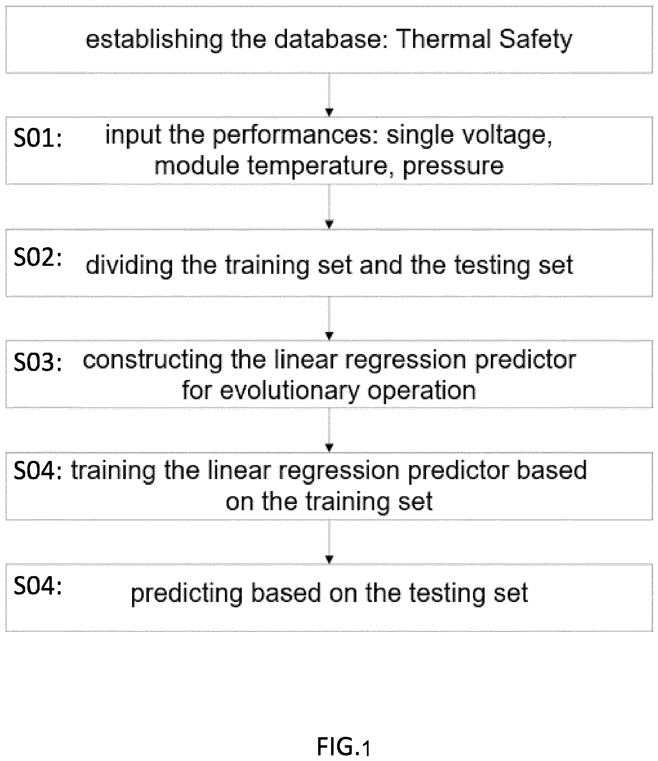

FIG.1

**REFERENCES CITED IN THE DESCRIPTION**

**Patent documents cited in the description**

- CN 113013514